**Europäisches Patentamt**

**European Patent Office**

**Office européen des brevets**

(11) Veröffentlichungsnummer: **0 099 043**
**B1**

(12) **EUROPÄISCHE PATENTSCHRIFT**

(45) Veröffentlichungstag der Patentschrift:
05.07.89

(51) Int. Cl.⁴: **G 01 R 21/00**

(21) Anmeldenummer: 83106516.4

(22) Anmeldetag: 04.07.83

(54) System zur Steuerung des elektrischen Energieverbrauchs, vorzugsweise in Haushalten.

(30) Priorität: 15.07.82 DE 3226544

(43) Veröffentlichungstag der Anmeldung:
25.01.84 Patentblatt 84/4

(45) Bekanntmachung des Hinweises auf die Patenterteilung:
05.07.89 Patentblatt 89/27

(84) Benannte Vertragsstaaten:
AT CH DE GB LI SE

(56) Entgegenhaltungen:
EP-A- 0 015 666
DE-A- 2 708 883
GB-A- 2 075 285
US-A- 3 906 242
US-A- 4 181 950

(73) Patentinhaber: Siemens Aktiengesellschaft Berlin und München, Wittelsbacherplatz 2, D-8000 München 2 (DE)

(72) Erfinder: Liska, Manfred, Dr., Würzburger Ring 33/13, D-8520 Erlangen (DE)
Erfinder: Schwendtner, Manfred, Dipl.-Ing., St. Gundekar-Strasse 3, D-8501 Schwarzenbruck (DE)
Erfinder: Wust, Karl-Ernst, Dipl.-Ing., Dahlmann-Strasse 6, D-8500 Nürnberg (DE)

ACTORUM AG

## Beschreibung

Die Erfindung betrifft ein System zur Steuerung des elektrischen Energieverbrauchs nach dem Oberbegriff des Patentanspruchs 1.

Ein derartiges System ist aus der DE-A-27 08 883 bekannt. Kern des bekannten Systems ist ein elektronischer Maximumwächter, dem Angaben über die Meßperiode und von einem Impulsgeberzähler eine Impulsfolge mit leistungsproportionaler Frequenz zugeführt sind. Dieser Maximumwächter weist einen Computer als Lastrechner und einen nichtflüchtigen Speicher für die Maximumüberwachung und die Einstellung mindestens eines Leistungsgrenzwertes und die Steuerung von Geräten über Schaltglieder auf. Die Prioritäten für die Ab- und Einschaltreihenfolge der Geräte sind hierbei im Lastrechner programmiert. Während jeder Meßperiode errechnet der Lastrechner aus der bereits verbrauchten Energie und der jeweiligen Augenblicksleistung, ob Geräte abzuschalten sind oder noch zugeschaltet werden können. Als zusätzliche Information ist im Speicher die Leistung der einzelnen Geräte abgelegt. Diese wird durch den Lastrechner aus der Änderung der augenblicklichen Gesamtleistung bei Zu- und Abschalten der einzelnen Geräte ermittelt. Aus diesen Leistungswerten und den programmierten Prioritäten ermittelt der Lastrechner selbsttätig die günstigste Ab- und Zuschaltung der einzelnen Geräte. Dieses System bietet gegenüber der zentral durch die Elektrizitätsversorgeunternehmen über Rundsteuerempfänger ausgelösten Ab- bzw. Zuschaltung leistungsintensiver Geräte einen höheren Komfort, da der Abnehmer elektrischer Energie selbst für die einzelnen Geräte die Prioritätsfolge vorgeben kann. Diese Prioritätsrangfolge wird jedoch zusätzlich durch die Einbeziehung der Leistung der einzelnen Geräte in den Entscheidungsprozeß über die Ab- bzw. Zuschaltung modifiziert. Dies kann dazu führen, daß die vom Abnehmer elektrischer Energie gewünschte Prioritätsfolge unter Berücksichtigung der Geräteleistung bei der Ab- bzw. Zuschaltung der Geräte außer Kraft gesetzt wird, so daß immer noch die Bedürfnisse des Abnehmers elektrischer Energie zu wenig berücksichtigende Schalthandlungen auftreten können.

Ein weiteres System dieser Art ist in der US-A-3 906 242 beschrieben. Auch bei diesem System sind elektrische Verbraucher über zugeordnete Schaltglieder von einem Lastrechner nach bestimmten Kriterien zu- und abschaltbar. Der Lastrechner weist einen nicht flüchtigen Datenspeicher auf, in den die von der thermischen oder der speichermengenabhängigen Trägheit der Geräte bestimmte Zeitkonstante abgelegt ist. Außerdem wird in diesen Speicher eine von einem Energiemeßfühler erzeugte elektrische Größe abgelegt, die mit derjenigen eines zugeordneten Energieüberwachungssystems beim Energieerzeuger korrespondiert. Darüber hinaus sind in dem Speicher die den einzelnen Geräten zugeordneten Betriebszeiten abgelegt. Der Rechner besitzt außerdem Vergleichsglieder, um die jeweils vom Elektrizitätsversorgungsunternehmen vorgegebenen Leistungswerte mit der tatsächlich entnommenen Leistung zu vergleichen. Aus den gespeicherten und den dem Rechner direkt zugeführten Werten ermittelt der Rechner die den angeschlossenen Geräten entsprechend ihren Prioritäten zu bestimmten Zeiten zugeordneten Ein- und Ausschaltimpulse. Dabei richten sich diese streng nach den im Rechner eingespeicherten Zuordnungen. Andere gewünschte Zuordnungen, beispielsweise in Abhängigkeit von der Jahreszeit, müssen durch Programmänderung in den Rechner eingegeben werden. Dieses System ist verhältnismäßig unflexibel.

Der Erfindung liegt die Aufgabe zugrunde, ein System der vorbeschriebenen bekannten Art dahingehend zu verbessern, daß eine benutzerfreundlichere Modifikation der Prioritätsfolge bei der Ab- bzw. Zuschaltung von Geräten bzw. Gerätegruppen erfolgt.

Diese Aufgabe wird durch die im Patentanspruch 1 angegebene Erfindung gelöst. Damit kann der elektrische Energieverbrauch eines Abnehmers vergleichmäßigt oder reduziert werden, wobei die programmierte Prioritätsfolge lediglich einen allgemeinen Rahmen für die Ab- und Zuschaltung der einzelnen Geräte oder Gerätegruppen bietet, der jedoch so abwandelbar ist, daß er für den Abnehmer elektrischer Energie mit der geringstmöglichen Beeinträchtigung verbunden ist. Wenn also beispielsweise für einen Heißwasserspeicher die niederwertigste Priorität gespeichert ist und in der Prioritätsfolge einem Gefrierschrank die nächsthöhere Priorität zugeordnet ist, dann wird nicht in allen Fällen, wenn der Leistungsistwert des Abnehmers den Grenzwert erreicht, der Heißwasserspeicher zuerst abgeschaltet, während der Gefrierschrank zunächst, wenn der Grenzwert nach Abschaltung des Heißwasserspeichers unterschritten bleibt, weiter betrieben würde. Wenn sich nämlich aufgrund der Zeitkonstanten und der bis zur Abschaltentscheidung verstrichenen Stromflußdauer ergibt, daß der Gefrierschrank nahezu seine untere Grenztemperatur erreicht hat, während der Heißwasserspeicher erst zu Beginn eines Aufheizzyklus steht, dann wird entgegen der an sich programmierten Prioritätsfolge der Gefrierschrank abgeschaltet, wohingegen der Heißwasserspeicher weiter aufgeheizt wird. Ganz analog wird durch den Lastrechner unter Berücksichtigung der Priorität, der Zeitkonstanten und der bisherigen Abschaltdauer die Zuschaltung von Geräten bzw. Gerätegruppen bestimmt. Damit wird für den Abnehmer elektrischer Energie durch die Abschaltung bzw. eine die Prioritätsfolge in Abhängigkeit von der Zeitkonstante und der bisherigen Abschaltdauer modifizierende Zuschaltung die geringstmögliche Beeinträchtigung des Nutzens seiner Geräte bzw. Gerätegruppen erreicht. Das Entscheidende ist also hierbei die Modifikation der programmierten Prioritätsfolge durch Einbeziehung der Vorgeschichte und der sich auf den Komfort des Abnehmers elektrischer Energie auswirkenden technischen Eigenschaften der Geräte bzw. Gerätegruppen zu einer die notwendigen Ab- und Zuschaltungen bestimmenden selbstadaptierenden Prioritätsfolge. Ein solches System kann beispielsweise für die einzelnen Geräte innerhalb einer Wohnung oder für ganze Gruppen von Geräten mit gleicher Zeitkonstante und vergleichbarer Stromflußdauer, beispielsweise innerhalb eines Hochhauses, eingesetzt sein. Unter Zeitkonstante wird hierbei bei temperaturgesteuerten Geräten, wie beispielsweise Kühlschränken, Gefrierschränken, Speicheröfen, Heißwasserspeichern, Elektroöfen, Nachtspeicheröfen, Klimaanlagen, die die thermische Trägheit beim Aufheizen bzw. Abkühlen des Gerätes bzw. des vom Gerät thermisch zu beeinflußenden Mediums bestimmende physikalische Größe verstanden. Bei nichttemperaturgesteuerten Geräten, beispielsweise einer Förderpumpe, die einen bestimmten Wasservorrat in einem Wasserspeicher bereitstellen soll, würde die «Zeitkonstante» beispielsweise aus dem vorhandenen Wasservorrat und der mittleren Entnahmemenge pro Zeiteinheit zu bestimmen sein.

In einer bevorzugten Ausführungsform ist für die Übertragung von Signalen vom Elektrizitätsversorgungsunternehmen (EVU) zum Abnehmen ein Empfänger vorgesehen, der an den Elektrizitätszähler und/oder den Lastrechner angeschlossen ist. Damit können beispielsweise Tarifumschaltungen am Elektrizitätszähler vorgenommen werden, aber auch für den Lastrechner entsprechende Grenzwerte vom EVU her eingestellt werden. Darüber hinaus kann in extremen Fällen an den Lastrechner der Befehl abgegeben werden, eine Notabschaltung, d.h. eine Betätigung aller Schaltglieder zur Gesamtabschaltung aller Geräte bzw. Gerätegruppen vorzunehmen. Damit kann durch das Elektrizitätsversorgungsunternehmen eine Beeinflussung des Systems von außen her vorgenommen werden. Durch die Vorgabe eines sehr niedrigen Grenzwertes für den Lastrechner kann damit eine zu hohe Lastspitze abgebaut werden, wobei durch den Lastrechner immer noch die für den Abnehmer elektrischer Energie am wenigsten lästige Alternative ausgewählt wird.

Darüber hinaus kann ein Sender für die Übertragung von Systemdaten zum Elektrizitätsversorgungsunternehmen vorgesehen sein. Ein solches Systemdatum kann beispielsweise die aktuelle Leistung darstellen, so daß beim Elektrizitätsversorgungsunternehmen ein differenziertes Bild über die Leistungsanforderung von beispielsweise einerseits Haushaltungen und andererseits Industrieanlagen entsteht. Darüber hinaus können diese Systemdaten auch Aufschluß darüber beim Elektrizitätsversorgungsunternehmen vermitteln, welche Arten von Geräten in einem Haushalt derzeit in Betrieb sind.

Eine vorteilhafte Ausführungsform besteht darin, daß der Lastrechner aufgrund eines am Empfänger bei Netzüberlastung eingehenden Signals entsprechend der vom Lastrechner modifizierten Prioritätsfolge je einen Abschaltbefehl mindestens an einzelne Schaltglieder abgibt, wobei eine manuelle Wiedereinschaltung ausgeschlossen ist. Durch das Ausschließen der an sich möglichen manuellen Wiedereinschaltung einzelner Schaltglieder wird in Notfällen dem Elektrizitätsversorgungsunternehmen die Möglichkeit gegeben, eine vom Abnehmer nicht mehr aufzuhebende Verringerung des elektrischen Energieverbrauchs oder Totalabschaltung der elektrischen Geräte oder Gerätegruppen zu erzwingen.

Der Lastrechner kann als programmierbarer Rechner mit mehreren Arbeitsprogrammen ausgeführt sein, wobei zumindest das die Abschaltung der Geräte oder Gerätegruppen nach Prioritätsfolge, Zeitkonstante und bisheriger Stromflußdauer bestimmende Programm durch ein am Empfänger eingehendes Signal aktivierbar ist. Damit besteht für das Elektrizitätsversorgungsunternehmen die zusätzliche Möglichkeit, unterschiedliche Arbeitsprogramme für den Lastrechner vorzugeben, was zu einer hohen Flexibilität des Systems führt.

Eine «sanfte» Form der Beeinflussung des Energieverbrauchs wird dadurch erreicht, daß der Elektrizitätszähler tarifumschaltbar ausgeführt ist. Hierbei erfolgt die Tarifumschaltung vorzugsweise durch den Lastrechner.

In einer alternativen Ausführungsform kann die Tarifumschaltung durch ein vom Elektrizitätsversorgungsunternehmen abgegebenes Signal über den Empfänger am Elektrizitätszähler auslösbar sein. Hierdurch wird das an sich weitgehend autarke System zur Steuerung des Energieverbrauchs der direkten Beeinflussung durch das Elektrizitätsversorgungsunternehmen zugänglich.

Es ist vorteilhaft, daß Elektrizitätszähler und Lastrechner als integrierte Baueinheit ausgeführt sind. In einer noch weiter gehenden Integrationsstufe können Sender, Empfänger, Lastrechner und Elektrizitätszähler als integrierte Baueinheit ausgeführt sein. Dies gestattet eine überaus kompakte Bauform und ermöglicht darüber hinaus die Doppelnutzung von Komponenten, also beispielsweise von Anzeigeeinheiten, Speichern oder auch des vorzugsweise als Mikrocomputer ausgeführten Lastrechners, der zusätzliche Aufgaben dieser Geräte übernehmen kann.

Als Übertragungsweg zwischen Elektrizitätsversorgungsunternehmen und Empfänger kann das elektrische Versorgungsnetz dienen. In gleicher Weise kann als Übertragungsweg zwischen Sender und EVU das elektrische Versorgungsnetz dienen. Gegenüber einer Übertragung durch elektromagnetische Wellen ist hierbei sichergestellt, daß ohne den Einsatz von den Aufwand erhöhenden Antennenanlagen Sender und Empfänger zuverlässig ansprechbar sind.

Der Grenzwert für den Lastrechner kann fest einprogrammiert sein. In einer größere Flexibilität gestattenden Ausführungsform kann jedoch der Grenzwert für den Lastrechner vom Elektrizitätsversorgungsunternehmen über den Empfänger dem Lastrechner vorgebbar sein.

In einer vorteilhaften Ausführungsform erfolgt bei einer Überschreitung des Grenzwertes über die Schaltglieder eine Abschaltung von Geräten oder Gerätegruppen für Zeitspannen, die ganzzahlige Vielfache der vom Meßperiodengeber vorgegebenen Meßperiode sind. Damit ist die Wiedereinschaltung der Geräte oder Gerätegruppen ohne die Etablierung eines eigenen Einschaltkriteriums, obwohl dieses eine noch höhere Anpassungsfähigkeit des Systemes gestattet, möglich. Falls nach Wiedereinschaltung immer noch eine Überschreitung des Grenzwertes vorliegt, erfolgt wiederum eine Abschaltung für eine festgelegte Zeit, so daß auch längere Abschaltungen immer als ganzzahlige Vielfache der Meßperiode aufbaubar sind, ohne daß komplizierte Einschaltkriterien benötigt werden.

In einer alternativen Ausführungsform können bei Überschreitung des Grenzwertes über die Schaltglieder periodische, im Vergleich zur Meßperiode erheblich kürzere Ein- und Abschaltungen einzelner Geräte oder Gerätegruppen durchgeführt werden, so daß der Betrieb der Geräte oder Gerätegruppen mit verringerter Leistung weitergeführt wird. Damit wird zwar die ans Elektrizitätsversorgungsunternehmen gerichtete Leistungsanforderung verringert, aber der Abnehmer elektrischer Energie kommt immer noch in den Genuß eines Teiles der Wirkung des Gerätes oder der Gerätegruppe. So kann beispielsweise durch getakteten Betrieb einer Klimaanlage ein Teil der gewünschten Kühlwirkung an heißen Sommertagen aufrecht erhalten werden, was für den Betreiber gegenüber einer Totalabschaltung immer noch die komfortablere Alternative ist.

In einer vorteilhaften Ausführungsform ist der Lastrechner zur Vorausberechnung des zu erwartenden Leistungsmaximums eingerichtet. Durch Vergleich mit dem einzuhaltenden Grenzwert für die elektrische Leistung kann somit frühzeitig ein Engpaß erkannt werden, so daß durch frühzeitige Abschaltungen einzelner Geräte oder Gerätegruppen vergleichsweise niedriger Prioritätsfolge die spätere Abschaltung von Geräten oder Gerätegruppen mit hoher Prioritätsfolge vermieden werden kann.

Es ist vorteilhaft, wenn jedes Schaltglied bistabiles Verhalten aufweist und durch Signale an mindestens einem Steuereingang in jeden der stabilen Zustände überführbar ist. Damit sind die vom Lastrechner gesteuerten Ab- und Einschaltungen ferngesteuert durchführbar. Zusätzlich kann das Schaltglied auch manuell betätigbar sein. Damit kann das Schaltglied den Geräteschalter direkt ersetzen.

Für den Abnehmer elektrischer Energie besteht somit die Möglichkeit, unerwünschte Schalthandlungen des Lastrechners manuell zu korrigieren. Um diese Korrekturmöglichkeit bei einer infolge Netzüberlastung nötig gewordenen Notabschaltung auszuschließen, kann das Schaltglied eine Verriegelungseinrichtung gegen manuelle Wiedereinschaltung aufweisen, die durch ein Signal am Steuereingang aktivierbar ist.

Der Sensor für den zum Gerät oder zur Gerätegruppe fließenden Strom kann im Schaltglied angeordnet sein. Da ohnehin jedes Gerät oder jede Gerätegruppe über ein Schaltglied an das speisende elektrische Netz angeschlossen ist, ist der Sensor ohne geräteseitige Eingriffe unterbringbar. Darüber hinaus kann das Schaltglied einen Überstromauslöser aufweisen, so daß im Falle einer Überlastung oder eines Kurzschlusses eine schnelle Abschaltung des Gerätes oder der Gerätegruppe möglich ist. Eine vorteilhafte Ausführungsform besteht darin, daß der Spannungsabfall an dem als Sensor genutzten stromdurchflossenen Element des Überstromauslösers an einem Ausgang des Schaltgliedes für die Rückmeldung zum Lastrechner zur Verfügung steht. Damit ist es nicht erforderlich, einen eigenen Sensor für den zum Gerät oder zur Gerätegruppe fließenden Strom vorzusehen, so daß Bauvolumen und Kosten eingespart werden. Der Überstromauslöser kann als thermischer Auslöser, also beispielsweise als Bimetallkontakt, oder als magnetischer Auslöser ausgebildet sein.

Es ist vorteilhaft, wenn für die Signalübertragung zwischen Lastrechner und Schaltglied eigene Signalleitungen vorgesehen sind. Gegenüber einer Funkübertragung ist dies in Gebäuden der zuverlässigere Übertragungsweg. Zu übertragen sind hierbei die Schaltbefehle des Lastrechners und das Ausgangssignal des Sensors für den Stromfluß.

Eine alternative Ausführungsform besteht darin, daß für die Signalübertragung zwischen Lastrechner und Schaltglied sowohl dem Lastrechner als auch dem Schaltglied ein Sender-Empfänger-Baustein zugeordnet ist, und daß die Signalübertragung in Form codierter Signale über die Speiseleitungen für die elektrische Energie des Gerätes oder der Gerätegruppe erfolgt. In diesem Fall wird die Installation eigener Signalleitungen eingespart.

In einer Einfachversion kann als Sensor für den zum Gerät oder zur Gerätegruppe fließenden Strom ein elektrischer Sensor für die Stellung des Schaltgliedes dienen. Damit wird nur Ja/Nein-Aussage gewonnen, was allerdings bei Geräten mit konstanter Leistungsaufnahme keine Probleme aufwirft, da ihr Stromfluß bekannt ist und im nichtflüchtigen Speicher des Lastrechners abgespeichert sein kann.

In einer alternativen Ausführungsform kann bei Geräten mit während eines Arbeitszyklus unterschiedlicher Leistungsaufnahme dem Sensor ein Grenzwertmelder nachgeschaltet sein, dessen Ausgangssignal nur bei leistungsintensiven Arbeitsabläufen des Arbeitszyklus aktiv ist. Damit werden nur die leistungsintensiven Arbeitsabläufe und zwar in Form einer Ja/Nein-Aussage erfaßt. Beispielsweise bei einer Waschmaschine erfolgt dann nur während des Arbeitsablaufs «Aufheizen» eine Rückmeldung zum Lastrechner, da die restlichen Arbeitsabläufe «Waschvorgang» und «Schleudervorgang» des Arbeitszyklus weniger leistungsintensiv sind.

Durch den Lastrechner kann eine Tarifumschaltung des Elektrizitätszählers auslösbar sein, wenn die Vorausberechnung des zu erwartenden Leistungsmaximum eine Überschreitung des Grenzwertes erwarten läßt. Wenn dies zusätzlich durch ein optisches oder akustisches Signal für den Abnehmer elektrischer Energie kenntlich gemacht wird, entsteht damit ein gewisser Kostendruck zur momentanen Verringerung und damit insgesamt zu einer Vergleichmäßigung des Energieverbrauchs.

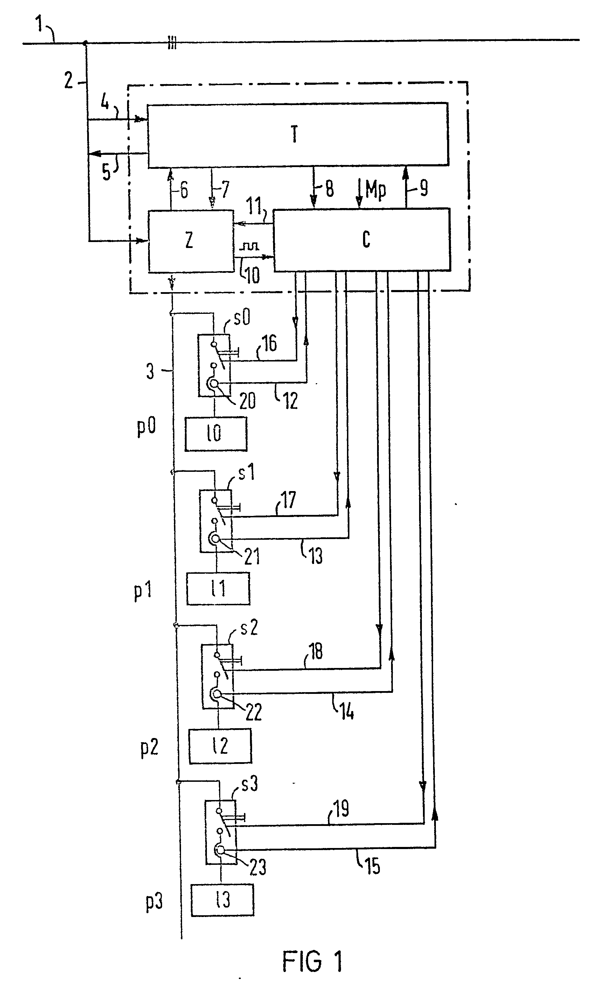

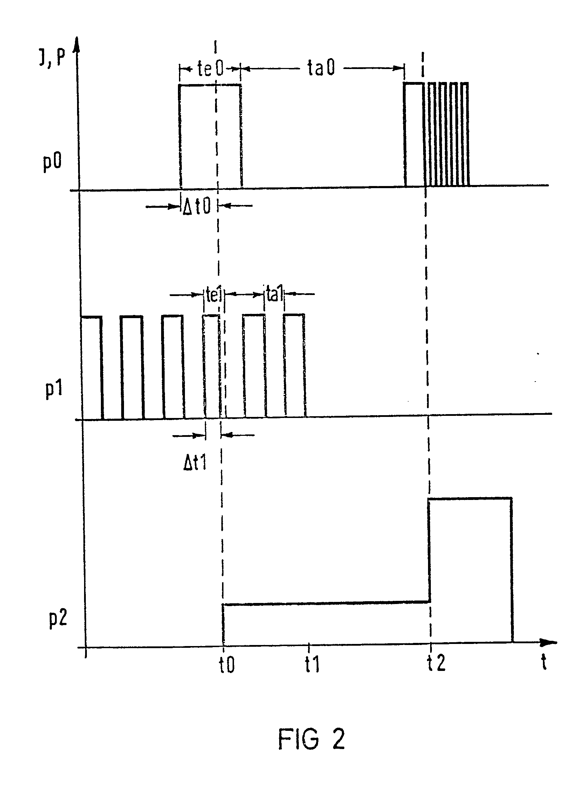

Die Erfindung wird im folgenden anhand eines Ausführungsbeispiels in den Fig. 1 und 2 näher erläutert. Dabei zeigt:

Fig. 1 ein Blockschaltbild des erfindungsgemäßen Systems und

Fig. 2 ein Funktionsdiagramm für die Modifikation der programmierten Prioritätsfolge durch den Lastrechner.

In Fig. 1 ist die elektrische Speiseleitung in einem Mehrfamilienwohnhaus mit dem Bezugszeichen 1 belegt. Von dieser Speiseleitung 1 zweigt die Leitung 2 ab, die der Versorgung einer einzelnen Wohnung des Mehrfamilienwohnhauses mit elektrischer Energie dient. Die Leitung 2 ist an den Elektrizitätszähler Z geführt, der als Impulsgeberzähler ausgebildet ist. Die Leitung 3 nach dem Elektrizitätszähler Z dient der Versorgung der elektrischen Geräte 10 bis 13 in der betreffenden Wohnung. Jedem dieser elektrischen Geräte 10 bis 13 ist ein Schaltglied s0 bis s3 zur Ein- und Abschaltung dieser Geräte vorgeschaltet. Diesen elektrischen Geräten 10 bis 13 sind von dem in dieser Wohnung wohnenden Abnehmer elektrischer Energie die Prioritätswerte p0 bis p3 zugeordnet. Dabei ist dem Gerät 10 die niederwertigste Priorität p0 zugeordnet, dem Gerät 13 die höchstwertige Priorität p3. Diese Prioritäten p0 bis p3 legen einen Rahmen für die vom Abnehmer als tolerabel empfundene Abschaltreihenfolge der elektrischen Geräte derart fest, daß das dem Abnehmer am unwichtigsten erscheinende Gerät die niederwertigste Priorität p0 und dem am wenigsten verzichtbar empfundenen Gerät 13 die höchste Priorität p3 zugeordnet ist. Als Gerät niedrigwertigster Priorität kommt beispielsweise ein Heißwasserspeicher infrage, als «Gerät» höchster Priorität kann beispielsweise die elektrische Beleuchtung oder die Speisung des Fernsehgerätes angesehen werden.

Das System zur Steuerung des elektrischen Energieverbrauches in dieser Wohnung umfaßt neben dem Elektrizitätszähler Z sowie den Schaltgliedern s0 bis s3 noch eine der Zweiwegekommunikation zwischen den Elektrizitätsversorgungsunternehmen und dem einzelnen Haushalt dienende Sender-Empfänger-Einheit T, die über die Leitung 4 Information in Form von Daten und Befehlen aus der Leitung 2 empfängt bzw. über die Leitung 5 an die Leitung 2 abgibt und damit zum Elektrizitätsversorgungsunternehmen emittiert. Die zwischen der Sender-Empfänger-Einheit T und dem Elektrizitätsversorgungsunternehmen auszutauschenden Informationen können beispielsweise in Form von aus der Rundsteuertechnik bekannten Impulsbildern codiert sein. Als vom Elektrizitätsversorgungsunternehmen zu den einzelnen Sender-Empfänger-Einheiten zu übertragende Informationen können beispielsweise Adressen der einzelnen Wohnungen, Tarifumschaltbefehle für die Umschaltung auf Hochtarif bzw. Niedertarif für als Zweitarifzähler ausgebildete Elektrizitätszähler unterschiedliche Leistungsgrenzwerte für den momentan zulässigen maximalen Energieverbrauch einer Wohnung oder Notabschaltbefehle für bestimmte Geräte, Gerätegruppen oder alle Geräte einer Wohnung sowie Befehle zur Aktivierung einzelner in einem Lastrechner C abgelegter Programme angesehen werden. Als vom Abnehmer elektrischer Energie über die Sender-Empfänger-Einheit an das Elektrizitätsversorgungsunternehmen zu liefernde Daten kämen beispielsweise Adressen der einzelnen Wohnungen, momentane Leistungsdaten, Zählerstände oder sonstige Zustandsdaten bezüglich der in der Wohnung aktiven elektrischen Geräte in Frage. Die Übertragung des Zählerstandes für Zwecke der Tariffernablesung erfolgt vom Elektrizitätszähler Z über die Leitung 6 zur Sender-Empfänger-Einheit T, wo er nach Codierung über die Leitung 5 an das speisende elektrische Netz abgegeben wird. Von der Sender-Empfänger-Einheit T empfangene Tarifumschaltbefehle werden über die Leitung 7 an den Elektrizitätszähler Z übermittelt. Alle anderen Informationen werden vorzugsweise über die Sender-Empfänger-Einheit T zum Lastrechner C oder vom Lastrechner C über die Leitungen 8 und 9 übertragen. Der Lastrechner C ist vorzugsweise als Mikrocomputer mit den zugehörigen Funktioneinheiten, wie Taktgeber, flüchtige und nichtflüchtige Speicher, Programmspeicher, Zentraleinheit, ausgebildet. Dieser Lastrechner hat wesentliche Funktionen eines weitgehend autarken Maximumwächters, dem über den Meßperiodeneingang MP Informationen über die Dauer der Meßperiode sowie über die Leitung 10 die von dem als Impulsgeberzähler ausgebildete Elektrizitätszähler Z eine Impulsfolge mit leistungsproportionaler Frequenz zugeführt sind. Der Informationsübertragung zwischen dem Lastrechner C und dem Elektrizitätszähler Z dient die Leitung 11, über die beispielsweise vom Lastrechner C ermittelte Tarifumschaltbefehle übertragen werden können.

Der Lastrechner C ermittelt für die einzelnen Meßperioden aus der über die Leitung 10 eingehenden Impulsfolge mit leistungsproportionaler Frequenz den entsprechenden Leistungsistwert und vergleicht diesen mit mindestens einem im Lastrechner vorhandenen Leistungsistwert. Dieser mindestens eine Leistungsistwert kann entweder fest einprogrammiert sein oder je nach dem Ergebnis einer Bilanz zwischen der zur Verfügung stehenden Leistung und der geforderten Leistung beim Elektrizitätsversorgungsunternehmen durch dieses über die Sender-Empfänger-Einheit T dem Lastrechner C zur Verfügung gestellt werden. In einem nichtflüchtigen Speicher des Lastrechners C stehen darüber hinaus die den einzelnen Geräten 10 bis 13 vom Abnehmer elektrischer Energie diesen Geräten zugeordneten Prioritäten in einer Prioritätsfolge sowie Informationen über die spezifischen Eigenschaften der Geräte in Form des das zeitliche Verhalten dieser Geräte im Bezug auf Ab- bzw. Einschaltungen widerspiegelnden Zeitkonstanten zur Verfügung. Zusätzlich erhält der Lastrechner C aktuelle Betriebsdaten der ein-

zelnen Geräte 10 bis 13 über die Leitungen 12 bis 15 in Form der zu den Geräten 10 bis 13 fließenden Ströme bzw. des Schaltzustandes der zugehörigen Schaltglieder s0 bis s3.

Der Lastrechner C kann zur Vorausberechnung des während jeder aktuellen Meßperiode zu erwartenden Leistungsmaximums aufgrund des vom Elektrizitätszähler Z in Form der Impulsfolge mit leistungsproportionaler Frequenz gelieferten Leistungsistwertes eingerichtet sein. In diese Vorausberechnung kann auch das unter der Wirkung einer häufig eingesetzten autarken Zweipunktregelung einzelner elektrischer Geräte zu erwartende Schaltverhalten einbezogen sein. Bei tatsächlicher oder aufgrund der Vorausberechnung zu erwartender Annäherung an den dem Lastrechner vorgegebenen Leistungsgrenzwert ermittelt dieser aus der vorgegebenen Prioritätsfolge, den Zeitkonstanten der einzelnen im Betrieb befindlichen Geräte und der bisherigen Stromflußdauer in diesen einzelnen Geräten, die den Abnehmer elektrischer Energie am wenigsten beeinträchtigende Abschaltung und Abschaltdauer für die einzelnen Geräte. Damit legt der Lastrechner C die für den betreffenden Abnehmer elektrischer Energie in weitgehender Autarkie von Eingriffen des Elektrizitätsversorgungsunternehmens die den einzelnen Abnehmer am wenigsten beeinträchtigende Abschaltung einzelner Geräte fest, wenn dies aufgrund einer erforderlichen Leistungsbegrenzung nötig erscheint. Allerdings hat das Elektrizitätsversorgungsunternehmen sinnvolle Eingriffsmöglichkeiten, beispielsweise durch die Vorgabe von Leistungsgrenzwerten oder die Aktivierung einzelner den Leistungsverbrauch mässigender Programme im Lastrechner. Zusätzlich kann das Elektrizitätsversorgungsunternehmen einen Befehl zur Notabschaltung übertragen, dessen Ausführung durch den Lastrechner C erfolgt. Dieser Befehl kann so geartet sein, daß entweder eine Abschaltung aller Geräte veranlaßt wird oder eine Abschaltung von Geräten bis zu einer bestimmten Prioritätsstufe.

Die Schaltglieder s0 bis s3 weisen bistabiles Verhalten auf und sind sowohl manuell betätigbar als auch durch elektrische Signale an mindestens einem Steuereingang in jeden ihrer beiden stabilen Zustände schaltbar. Diese die Schalthandlung herbeiführenden Signale werden im Lastrechner C erzeugt und über die Leitungen 16 bis 19 auf die Schaltglieder übertragen. Die Leitungen 16 bis 19 zwischen dem Lastrechner C und den Schaltgliedern s0 bis s3 erfordern einen gewissen Installationsaufwand. Dieser ist vermeidbar, wenn zur Übertragung der die Schalthandlungen der Schaltglieder auslösenden Signale das installierte elektrische Netz, also die Leitung 3 benutzt wird. In diesem Fall werden die den einzelnen Schaltgliedern s0 bis s3 zugeordneten Signale zur Durchführung von Schalthandlungen nach entsprechender Codierung direkt auf die Leitung 3 übertragen, so daß sie von den einzelnen Schaltgliedern s0 bis s3 zugeordneten Empfängern erkannt und zur Auslösung der Schalthandlung an das entsprechende Schaltglied weitergegeben werden können. Hierbei kann man sich ähnlicher Verfahren wie bei der Rundsteuertechnik bedienen. Die Schaltbefehle können demnach beispielsweise nach dem Impulsabstandsverfahren oder nach dem Impulsmusterverfahren übertragen werden. Die entsprechende Codierung kann durch den Lastrechner mit übernommen werden. Für den Fall der Notabschaltung ist jedes Schaltglied mit einer Verriegelungseinrichtung versehen, die eine manuelle Wiedereinschaltung ausschließt und die durch ein entsprechendes Steuersignal aktivierbar ist. Dies kann dadurch realisiert sein, daß jedes der Schaltglieder s0 bis s3 eine die Abschaltung bewirkende Auslösespule enthält, die im Fall der Notabschaltung eine Dauererregung erhält. Zur Erfassung des zu den Geräten 10 bis 13 fließenden Stromes ist in jedem der Schaltglieder s0 bis s3 ein Sensor 20 bis 23 vorgesehen. Darüber hinaus kann in jedes der Schaltglieder s0 bis s3 zum Schutz gegen Überlastung ein Überstromauslöser eingebaut sein. Dies bietet die Möglichkeit, daß das stromdurchflossene Element des Überstromauslösers gleichzeitig als Sensor des zum zugehörigen Gerät 10 bis 13 fließenden Stromes genutzt wird, indem der an diesem Element auftretende Spannungsabfall über die Leitungen 12 bis 15 zum Lastrechner C zurückgemeldet wird. Bei Geräten, die im Einschaltzustand eine konstante Strom- bzw. Leistungsaufnahme aufweisen, ist es ausreichend, als Sensor für den zum Gerät fließenden Strom einen elektrischen Sensor für die Stellung des Schaltgliedes einzusetzen. Die Information über den konstanten Strom- bzw. Leistungsverbrauch ist in diesem Fall in einem nichtflüchtigen Speicher des Lastrechners abzulegen.

Geräte mit nichtkonstanter Leistungsaufnahme sind solche, die einen komplizierten Arbeitszyklus mit verschiedenen Arbeitsabläufen · aufweisen, also beispielsweise Waschmaschinen. In diesem Fall genügt es, nur die leistungsintensiven Arbeitsabläufe an den Lastrechner C zurückzumelden. In diesem Fall ist dem Sensor für den zum Gerät fließenden Strom ein Grenzwertmelder nachzuschalten, dessen Ausgangssignal nur bei leistungsintensiven Arbeitsabläufen des Arbeitszyklus aktiv ist.

Die vom Lastrechner C über die Leitung 11 veranlaßte Tarifumschaltung des Elektrizitätszählers Z kann bei einem zur Vorausberechnung des zu erwartenden Leistungsmaximums eingerichteten Lastrechner dann ausgelöst werden, wenn die Vorausberechnung des zu erwartenden Leistungsmaximums eine Überschreitung des Grenzwertes erwarten läßt. Der Elektrizitätszähler Z und der Lastrechner können als integrierte Baueinheit ausgeführt sein. In diese integrierte Baueinheit kann auch zusätzlich die Sender-Empfänger-Einheit T einbezogen sein. Bei einem unter Einsatz eines Mikrocomputers aufgebauten Lastrechner C kann der Mikrocomputer Funktionen des Elektrizitätszählers Z sowie der Sender-Empfänger-Einheit T mit übernehmen. Dies ist durch die strichpunktierte Umrandung der Blöcke C, Z, T angedeutet.

In Fig. 2 ist ein Beispiel für eine aufgrund der Arbeitsweise des Lastrechners erfolgende Modifizierung der Prioritätsfolge beim Abschalten von Geräten veranschaulicht. Die Abszisse des Diagramms in Fig. 2 stellt eine Zeitachse dar, die Ordinate repräsentiert den Gerätestrom bzw. die Geräteleistung. In der obersten Zeile ist die Leistungsentnahme eines elektrischen Gerätes mit der niederwertigsten Priorität p0, in der mittleren Zeile die Leistungsentnahme eines Gerätes mit der nächsthöheren Priorität p1 und in der unteren Zeile die Leistungsentnahme eines Gerätes mit der wiederum höheren Priorität p2 dargestellt. Im Zeitpunkt t0 überschreitet der Leistungsistwert den vorgegebenen Leistungsgrenzwert. Bei einer rein prioritätsgesteuerten Abschaltung durch den Lastrechner C würde in diesem Fall das Gerät mit der Priorität p0 unabhängig von dessen technischen Eigenschaften und Vorgeschichte abgeschaltet werden. Bei dem erfindungsgemäßen Lastrechner wird jedoch der Betrieb des Gerätes mit der Priorität p0 weitergeführt und stattdessen das Gerät mit der Priorität p1 abgeschaltet. Da im Lastrechner C Informationen über die Zeitkonstanten oder die im regulären Zweipunktbetrieb auftretenden Ein- und Abschaltzeiten te0, te1 bzw. ta0, ta1 vorhanden sind und darüber hinaus aus der Erfassung der letzten Stromflußdauern Δt0 und Δt1 hervorgeht, daß das Gerät mit der Priorität p0 gerade erst etwas mehr als die Hälfte seiner an sich notwendigen Einschaltdauer aufweist, wohingegen das Gerät mit der Priorität p1 bereits fast für seine gesamte Einschaltdauer mit Strom versorgt wurde, wird entgegen der an sich programmierten Prioritätsfolge die geringstmögliche Beeinträchtigung für den Abnehmer elektrischer Energie durch Abschaltung des Gerätes mit der Priorität p1 erreicht.

Im Zeitpunkt t1 geht das Gerät mit der Priorität p1 außer Betrieb. Dieses Gerät kann beispielsweise eine Klimaanlage im Kühlbetrieb sein, deren Betrieb wegen einer abendlichen Abkühlung überflüssig wird. Im Zeitpunkt t2 beginnt das Gerät mit der Priorität p2 einen sehr leistungsintensiven Arbeitsablauf im Rahmen seines Arbeitszyklus, so daß eine erneute Überschreitung des Leistungsgrenzwertes erfolgt. In diesem Fall wird die programmierte Prioritätsfolge beibehalten, wobei das Gerät mit niedrigster Priorität p0 nicht abgeschaltet, sondern mit verringerter Leistung betrieben wird, indem es periodisch mit hoher Taktfrequenz für den Rest seiner Einschaltdauer ein- und ausgeschaltet wird.

## Patentansprüche

1. System zur Steuerung des elektrischen Energieverbrauches, vorzugsweise in Haushalten, mit einem Elektrizitätszähler (Z), der ausgangsseitig eine Impulsfolge mit leistungsproportionaler Frequenz an einen Lastrechner (C) abgibt, mit einem Meßperiodengeber und mit Schaltgliedern (s0–s3), die den einzelnen energieverbrauchenden Geräten oder Gerätegruppen (10–13) zugeordnet sind, wobei diese Schaltglieder vom Lastrechner als Ergebnis eines Vergleiches zwischen einem von der Netzbelastung abhängigen Grenzwert und dem ermittelten Leistungsistwert für eine Meßperiode unter Berücksichtigung einer in einem nicht flüchtigen Speicher des Lastrechners (C) abgelegten zeitabhängigen Prioritätsfolge des Betriebes, der Werte der elektrischen Leistung der Geräte oder Gerätegruppen (10–13) sowie der von der thermischen oder der speichermengenabhängigen Trägheit bestimmten Zeitkonstanten der Geräte oder Gerätegruppen (10–13) beeinflußbar sind, dadurch gekennzeichnet, daß jedem Gerät oder jeder Gerätegruppe (10–13) ein Stromsensor (20–23) für den zum Gerät fließenden Strom zugeordnet ist, dessen Ausgangssignal dem Lastrechner (C) zugeführt ist, und daß die Zu- und Abschaltung von Geräten oder Gerätegruppen (10–13) bei Erreichen des Grenzwertes in Abhängigkeit sowohl von der Prioritätsfolge wie von deren individuellen Zeitkonstanten und Stromflußzeiten in der Weise erfolgt, daß dann, wenn sich aufgrund der Zeitkonstante und der bis zur Abschaltung verstrichenen Stromflußdauer ergibt, daß ein prioritätshöheres Gerät seinen betriebsmäßigen Endzustand nahezu erreicht hat, während sich ein prioritätsniedrigeres Gerät erst im Anfangszustand befindet, das prioritätshöhere Gerät vorzeitig abgeschaltet und das prioritätsniedrigere Gerät eingeschaltet wird und umgekehrt.

2. System nach Anspruch 1, dadurch gekennzeichnet, daß für die Übertragung von Signalen vom Elektrizitätsversorgungsunternehmen zum Abnehmer ein Empfänger (T) vorgesehen ist, der an den Elektrizitätszähler (Z) und/oder den Lastrechner (C) angeschlossen ist.

3. System nach Anspruch 1 oder 2, dadurch gekennzeichnet, daß ein Sender (T) für die Übertragung von Systemdaten zum Elektrizitätsversorgungsunternehmen vorgesehen ist.

4. System nach Anspruch 2 oder 3, dadurch gekennzeichnet, daß der Lastrechner (C) aufgrund eines am Empfänger (T) bei Netzüberlastung eingehenden Signals entsprechend der vom Lastrechner (C) modifizierten Prioritätsfolge je einen Abschaltbefehl mindestens an einzelne Schaltglieder (s0 bis s3) abgibt, wobei eine manuelle Wiedereinschaltung ausgeschlossen ist.

5. System nach einem der Ansprüche 2 bis 4, dadurch gekennzeichnet, daß der Lastrechner (C) als programmierbarer Rechner mit mehreren Arbeitsprogrammen ausgeführt ist, wobei zumindest das die Abschaltung der Geräte (10 bis 13) oder Gerätegruppen nach Prioritätsfolge (p0, p1, p2), Zeitkonstante und bisherige Stromflußdauer bestimmende Programm durch ein am Empfänger (T) eingehendes Signal aktivierbar ist.

6. System nach einem der Ansprüche 1 bis 5, dadurch gekennzeichnet, daß der Elektrizitätszähler (Z) tarifumschaltbar ausgeführt ist.

7. System nach einem der Ansprüche 2 bis 6, dadurch gekennzeichnet, daß die Tarifumschaltung durch ein vom Elektrizitätsversorgungsunternehmen gegebenes Signal über den Empfänger (T) am Elektrizitätszähler (Z) auslösbar ist.

8. System nach einem der Ansprüche 1 bis 7, dadurch gekennzeichnet, daß Elektrizitätszähler (Z) und Lastrechner (C) als integrierte Baueinheit ausgeführt sind.

9. System nach einem der Ansprüche 3 bis 8, dadurch gekennzeichnet, daß Sender (T), Empfänger (T), Lastrechner (C) und Elektrizitätszähler (Z) als integrierte Baueinheit ausgeführt sind.

10. System nach Anspruch 2, dadurch gekennzeichnet, daß als Übertragungsweg zwischen Elektrizitätsversorgungsunternehmen und Empfänger (T) das elektrische Versorgungsnetz (1, 2) dient.

11. System nach Anspruch 3, dadurch gekennzeichnet, daß als Übertragungsweg zwischen Sender (T) und Elektrizitätsversorgungsunternehmen das elektrische Versorgungsnetz (1, 2) dient.

12. System nach einem der Ansprüche 1 bis 11, dadurch gekennzeichnet, daß der Grenzwert für den Lastrechner (C) fest einprogrammiert ist.

13. System nach einem der Ansprüche 1 bis 11, dadurch gekennzeichnet, daß der Grenzwert für den Lastrechner (C) vom Elektrizitätsversorgungsunternehmen über den Empfänger (T) dem Lastrechner (C) vorgebbar ist.

14. System nach einem der Ansprüche 1 bis 13, dadurch gekennzeichnet, daß bei Überschreitung des Grenzwertes über die Schaltglieder (s0 bis s3) eine Abschaltung von Geräten (10 bis 13) oder Gerätegruppen für Zeitspannen erfolgt, die ganzzahlige Vielfache der vom Meßperiodengeber (MP) vorgegebenen Meßperiode sind.

15. System nach einem der Ansprüche 1 bis 13, dadurch gekennzeichnet, daß bei Überschreitung des Grenzwertes über die Schaltglieder (s0 bis s3) periodische im Vergleich zur Meßperiode erheblich kürzere Ein- und Abschaltungen einzelner Geräte (10 bis 13) oder Gerätegruppen durchgeführt werden, so daß der Betrieb der Geräte (10 bis 13) oder Gerätegruppen mit verringerter Leistung weitergeführt wird.

16. System nach einem der Ansprüche 1 bis 15, dadurch gekennzeichnet, daß der Lastrechner (C) zur Vorausberechnung des zu erwartenden Leistungsmaximums eingerichtet ist.

17. System nach einem der Ansprüche 1 bis 16, dadurch gekennzeichnet, daß jedes Schaltglied (s0 bis s3) bistabiles Verhalten aufweist und durch Signale an mindestens einem Steuereingang in jeden der stabilen Zustände überführbar ist.

18. System nach Anspruch 17, dadurch gekennzeichnet, daß das Schaltglied (s0 bis s3) auch manuell betätigbar ist.

19. System nach Anspruch 18, dadurch gekennzeichnet, daß das Schaltglied (s0 bis s3) eine Verriegelungseinrichtung gegen manuelle Wiedereinschaltung aufweist, die durch ein Signal am Steuereingang aktivierbar ist.

20. System nach einem der Ansprüche 17 bis 19, dadurch gekennzeichnet, daß der Sensor (20 bis 23) für den zum Gerät (11 bis 13) oder zur Gerätegruppe fließenden Strom im Schaltglied (s0 bis s3) angeordnet ist.

21. System nach einem der Ansprüche 17 bis 20, dadurch gekennzeichnet, daß das Schaltglied (s0 bis s3) einen Überstromauslöser aufweist.

22. System nach den Ansprüchen 20 und 21, dadurch gekennzeichnet, daß der Spannungsabfall an dem als Sensor genutzten stromdurchflossenen Element des Überstromauslösers an einem Ausgang des Schaltgliedes (s0 bis s3) für die Rückmeldung zum Lastrechner (C) zur Verfügung steht.

23. System nach einem der Ansprüche 1 bis 22, dadurch gekennzeichnet, daß für die Signalübertragung zwischen Lastrechner (C) und Schaltglied (s0 bis s3) eigene Signalleitungen (12 bis 15, 16 bis 19) vorgesehen sind.

24. System nach einem der Ansprüche 1 bis 22, dadurch gekennzeichnet, daß für die Signalübertragung zwischen Lastrechner (C) und Schaltglied (s0 bis s3) sowohl dem Lastrechner (C) als auch dem Schaltglied (s0 bis s3) ein Senderempfängerbaustein zugeordnet ist und daß die Signalübertragung in Form codierter Signale über die Speiseleitung (3) für die elektrische Energie des Gerätes (10 bis 13) erfolgt.

25. System nach Anspruch 20, dadurch gekennzeichnet, daß als Sensor (20 bis 23) für den zum Gerät (10 bis 13) oder zur Gerätegruppe fließenden Strom ein elektrischer Sensor für die Stellung des Schaltgliedes (s0 bis s3) dient.

26. System nach Anspruch 20, dadurch gekennzeichnet, daß bei Geräten (10 bis 13) mit während eines Arbeitszyklus unterschiedlicher Leistungsaufnahme dem Sensor (20 bis 23) ein Grenzwertmelder nachgeschaltet ist, dessen Ausgangssignal nur bei leistungsintensiven Arbeitsabläufen des Arbeitszyklus aktiv ist.

27. System nach den Ansprüchen 6 bis 16, dadurch gekennzeichnet, daß durch den Lastrechner (C) eine Tarifumschaltung des Elektrizitätszählers (Z) auslösbar ist, wenn die Vorausberechnung des zu erwartenden Leistungsmaximums eine Überschreitung des Grenzwertes erwarten läßt.

**Claims**

1. System for controlling the electrical energy consumption, preferably in households, with an electricity meter (Z) which, on the output side, delivers to a load calculator (C) a pulse train, having a frequency which is proportional to the power, with a measurement period generator and with switching elements (s0–s3), which are assigned to the individual energy-consuming apparatus or apparatus groups (10–13), whereby these switching elements are able to be influenced by the load calculator as a result of a comparison between one limiting value dependent on the network load and the determined actual power value for a measurement period under consideration of a priority sequence of the operation, dependent on time, and distributed in a non-volatile memory of the load calculator (C), of the values of the electrical power of the apparatus or apparatus groups (10–13) as well as of the time constants of the apparatus or apparatus groups (10–13) determined by the thermal inertia or inertia dependent on the memory quantity, characterised in that to each apparatus or each apparatus group (10–13) there is assigned a current sensor (20–23) for the current flowing to the apparatus, the output signal of which is led to the load calculator (C) and in that the disconnection and connection of apparatus or apparatus groups (10–13) when reaching the limiting value depending on the priority sequence, as well as on the individual time constants and current flow times thereof, occur in such a way that if the result, because of the time constants and the current flow duration spreading to the disconnection, is that a high-priority apparatus has almost reached its operational end state, whilst a low-priority apparatus is first located in the commencing state, the high-priority apparatus disconnects prematurely and the low-priority apparatus switches and vice versa.

2. System according to claim 1, characterised in that for the transmission of signals from the electricity-supply company to the consumer, a receiver (T) is provided which is attached to the electricity meter (Z) and/or the load calculator (C).

3. System according to claim 1 or 2, characterised in that a transmitter (T) is provided for the transmission of system data to the electricity-supply company.

4. System according to claim 2 or 3, characterised in that the load calculator (C), because of a signal corresponding to the priority sequence modified by the load calculator (C) entering the receiver (T), with the network overloading, transmits in each case one disconnection command at least to individual switching elements (s0 to s3), whereby a manual reclosure is excluded.

5. System according to one of claims 2 to 4, characterised in that the load calculator (C) is designed as programmable calculator with several function programs, whereby at least the program determining the disconnection of the apparatus (10 to 13) or apparatus groups according to the priority sequence (p0, p1, p2), time constants and former current flow duration, is able to be activated by a signal entering the receiver (T).

6. System according to one of claims 1 to 5, characterised in that the electricity meter (Z) is designed so that the rate can be changed.

7. System according to one of claims 2 to 6, characterised in that the rate changing is able to be released by a signal given by the electricity-supply company by way of the receiver (T) on the electricity meter (Z).

8. System according to one of claims 1 to 7, characterised in that electricity meter (Z) and load calculator (C) are designed as an integrated basic unit.

9. System according to one of claims 3 to 8, characterised in that transmitter (T), receiver (T), load calculator (C) and electricity meter (Z) are designed as an integrated basic unit.

10. System according to claim 2, characterised in that serving as a transmission path between electricity-supply company and receiver (T) there is the electric supply network (1, 2).

11. System according to claim 3, characterised in that serving as a transmission path between transmitter (T) and electricity-supply company there is the electric supply network (1, 2).

12. System according to one of claims 1 to 11, characterised in that the limiting value for the load calculator (C) is programmed in a fixed manner.

13. System according to one of claims 1 to 11, characterised in that the limiting value for the load calculator (C) is able to be advanced to the load calculator (C) by the electricity-supply company by way of the receiver (T).

14. System according to one of claims 1 to 13, characterised in that, when the limiting value is exceeded, a disconnection of apparatus (10 to 13) or apparatus groups, by means of the switching elements (s0 to s3), occurs for time intervals, which are integral multiples of the integration period advanced by the integration period generator (MP).

15. System according to one of claims 1 to 13, characterised in that, when the limiting value is exceeded, periodic, and in comparison with integration periods, considerably shorter connection and disconnection of individual apparatus (10 to 13) or apparatus groups are carried out by way of the switching elements (s0 to s3), so that the operation of the apparatus (10 to 13) or apparatus groups is further carried out with reduced performance.

16. System according to one of claims 1 to 15, characterised in that the load calculator (C) is set up for predetermining the expected maximum power.

17. System according to one of claims 1 to 16, characterised in that each switching element (s0 to s3) has bistable behaviour and is able to be switched over by means of signals at at least one control input in each of the stable conditions.

18. System according to claim 17, characterised in that the switching element (s0 to s3) is also able to be activated manually.

19. System according to claim 18, characterised in that the switching element (s0 to s3) has an interlocking device against manual reclosure which is able to be activated by a signal at the control input.

20. System according to one of claims 17 to 19, characterised in that the sensor (20 to 23) is arranged for the current flowing to the apparatus (11 to 13) or to the apparatus group in the switching element (s0 to s3).

21. System according to one of claims 17 to 20, characterised in that the switching element (s0 to s3) has an over-current release.

22. System according claims 20 to 21, characterised in that the voltage drop at the element of the over-current release, with current flowing through it, used as sensor, is available at the output of the switching element (s0 to s3) for the check-back signal to the load calculator (C).

23. System according to one of claims 1 to 22, characterised in that for the signal transmission between load calculator (C) and switching element (s0 to s3) individual signal lines (12 to 15, 16 to 19) are provided.

24. System according to one of claims 1 to 22, characterised in that for the signal transmission between load calculator (C) and switching element (s0 to s3) there is assigned to the load calculator (C) as well as the switching element (s0 to s3) a sender-receiver block and that the signal transmission occurs in the form of coded signal by way of the supply line (3) for the electric energy of the apparatus (10 to 13).

25. System according to claim 20, characterised in that as sensor (20 to 23) for the current flowing to the apparatus (10 to 13) or to the apparatus group there serves an electric sensor for the position of the switching element (s0 to s3).

26. System according to claim 20, characterised in that with apparatus (10 to 13) with a varying power input during a working cycle, connected downstream of the sensor (20 to 23) there is a limiting value monitor, the output signal of which is only active with performance intensive operating periods of the working cycle.

27. System according to claims 6 to 16, characterised in that a change of rate of the electricity counter (Z) is able to be released by the load calculator (C), if the predetermining of the maximum performance to be expected has the effect that exceeding the limiting value is expected.

## Revendications

1. Système pour commander la consommation en énergie électrique, de préférence pour usage domestique, comportant un compteur électrique (Z) qui délivre, sur sa sortie, une suite d'impulsions possédant une fréquence proportionnelle à la puissance, à un calculateur de charge (C), un générateur de périodes de mesure et des circuits de coupure (s0–s3), qui sont associés aux différents appareils ou groupes d'appareils (10–13) consommant de l'énergie, ces circuits de coupure pouvant être influencés par le calculateur de charge, sur la base du résultat d'une comparaison entre une valeur limite dépendant de la charge du réseau, et la valeur réelle de puissance déterminée, pour une période de mesure, compte tenu de la séquence des priorités de fonctionnement, qui dépend du temps et est mémorisée dans la mémoire du calculateur de charge (C), de la valeur de la puissance électrique des appareils ou des groupes d'appareils (10–13) ainsi que des constantes de temps des appareils ou des groupes d'appareils (10–13), déterminées par l'inertie thermique ou par l'inertie dépendant de la capacité de mémoire, caractérisé par le fait qu'à chaque appareil ou à chaque groupe d'appareils (10–13) est associé un détecteur (20–23), qui sert à détecter le courant envoyé à l'appareil et dont le signal de sortie est envoyé au calculateur de charge (C), et que le branchement et le débranchement d'appareils ou de groupes d'appareils (10–13), lorsque la valeur limite est atteinte, s'effectuent en fonction aussi bien de la séquence des priorités que des constantes de temps individuelles et des durées de circulation du courant pour ces appareils ou groupes d'appareils, de telle sorte que, lorsque sur la base de la constante de temps et de la durée de circulation du courant qui s'est écoulée jusqu'au débranchement, il s'avère qu'un appareil possédant une priorité plus élevée a presque atteint son état final conforme au fonctionnement, tandis qu'un appareil possédant une priorité plus faible se trouve seulement dans son état initial, l'appareil possédant la priorité la plus élevée est débranché prématurément et l'appareil possédant la priorité la plus faible est branché, et inversement.

2. Système selon la revendication 1, caractérisé par le fait que, pour la transmission de signaux depuis l'entreprise de distribution d'électricité à l'utilisateur, il est prévu un récepteur (T) raccordé au compteur électrique (Z) et/ou au calculateur de charge (C).

3. Système suivant la revendication 1 ou 2, caractérisé par le fait qu'il est prévu un émetteur (T) pour la transmission de données du système à l'entreprise de distribution d'électricité.

4. Système selon la revendication 2 ou 3, caractérisé par le fait que le calculateur de charge (C) délivre, sur la base d'un signal arrivant dans le récepteur (T) dans le cas d'une surcharge du réseau, et conformément à la séquence de priorités modifiée par le calculateur de charge (C), une instruction respective de débranchement au moins à des circuits de coupure individuels (s0 à s3), un rebranchement manuel étant exclu.

5. Système suivant l'une des revendications 2 à 4, caractérisé par le fait que le calculateur de charge (C) est réalisé sous la forme d'un calculateur programmable comportant plusieurs programmes de travail, au moins le débranchement des appareils (10 à 13) ou des groupes d'appareils pouvant être déclenché selon la séquence de priorités (p0, p1, p2), de la constante de temps et d'un programme déterminant une durée écoulée de circulation du courant, au moyen d'un signal pénétrant dans le récepteur (T).

6. Système suivant l'une des revendications 1 à 5, caractérisé par le fait que le compteur électrique (Z) est conçu de manière à permettre une commutation de tarif.

7. Système suivant l'une des revendications 2 à 6, caractérisé par le fait que la commutation de tarif peut être déclenchée par un signal, délivré par l'entreprise de distribution d'électricité, au compteur électrique (Z) par l'intermédiaire du récepteur (T).

8. Système suivant l'une des revendications 1 à 7, caractérisé par le fait que le compteur électrique (Z) et le calculateur de charge (C) sont réalisés sous la forme d'un module intégré.

9. Système suivant l'une des revendications 3 à 8, caractérisé par le fait que l'émetteur (E), le récepteur (A), le calculateur de charge (C) et le compteur électrique (Z) sont réalisés sous la forme d'un module intégré.

10. Système suivant la revendication 2, caractérisé par le fait qu'on utilise, comme voie de transmission entre l'entreprise de distribution d'électricité et le récepteur (E), le réseau d'alimentation électrique (1, 2).

11. Système suivant la revendication 3, caractérisé par le fait qu'on utilise comme voie de transmission entre l'émetteur (T) et l'entreprise de distribution d'électricité, le réseau d'alimentation électrique (1, 2).

12. Système suivant l'une des revendications 1 à 11, caractérisé par le fait que la valeur limite pour le calculateur de charge (C) est programmée de façon fixe.

13. Système suivant l'une des revendications 1 à 11, caractérisé par le fait que la valeur limite pour le calculateur de charge (C) peut être envoyée de façon prédéterminée au calculateur de charge (C) par l'entreprise de distribution d'électricité par l'intermédiaire du récepteur (T).

14. Système suivant l'une des revendications 1 à 13, caractérisé par le fait que, dans le cas du dépassement de la valeur limite, un débranchement d'appareils (10 à 13) ou de groupes d'appareils est réalisé, par l'intermédiaire des circuits de coupure (s0 à s3), pendant des intervalles de temps, qui sont égaux à des multiples entiers de la période de mesure prédéterminée par le générateur (MP) de périodes de mesure.

15. Système suivant l'une des revendications 1 à 13, caractérisé par le fait que, dans le cas d'un dépassement de la valeur limite, des branchements et débranchements périodiques, d'une durée nettement inférieure à la période de mesure, d'appareils individuels (10 à 13) ou de groupes d'appareils sont exécutés par l'intermédiaire des circuits de coupure (s0 à s3) de sorte que le fonctionnement des appareils (10 à 13) ou des groupes d'appareils se poursuit avec une puissance réduite.

16. Système suivant l'une des revendications 1 à 15, caractérisé par le fait que le calculateur de charge (C) est agencé pour calculer par avance le maximum de puissance, auquel on peut s'attendre.

17. Système suivant l'une des revendications 1 à 16, caractérisé par le fait que chaque circuit de coupure (s0 à s3) possède un comportement bistable et peut être commuté, au moyen de signaux appliqués à au moins une entrée de commande, dans chacun des états stables.

18. Système suivant la revendication 17, caractérisé par le fait que le circuit de coupure (s0 à s3) peut être également actionné manuellement.

19. Système suivant la revendication 18, caractérisé par le fait que le circuit de coupure (s0 à s3) possède un dispositif de verrouillage vis-à-vis d'un rebranchement manuel, qui peut être activé au moyen d'un signal appliqué à l'entrée de commande.

20. Système suivant l'une des revendications 17 à 19, caractérisé par le fait que le détecteur (20 à 23) détectant le courant aboutissant à l'appareil (11 à 13) ou au groupe d'appareils est disposé dans le circuit de coupure (s0 à s3).

21. Système suivant l'une des revendications 17 à 20, caractérisé par le fait que le circuit de coupure (s0 à s3) comporte un déclencheur à maximum.

22. Système suivant les revendications 20 et 21, caractérisé par le fait que la chute de tension dans l'élément, utilisé comme détecteur et parcouru par le courant, du déclencheur à maximum est disponible sur une sortie du circuit de coupure (s0 à s3) pour la signalisation en retour au calculateur de charge (C).

23. Système suivant l'une des revendications 1 à 22, caractérisé par le fait que pour la transmission de signaux entre le calculateur de charge (C) et le circuit de coupure (s0 à s3), il est prévu des lignes particulières (12 à 15, 16 à 19) de transmission des signaux.

24. Système suivant l'une des revendications 1 à 22, caractérisé par le fait que, pour la transmission de signaux entre le calculateur de charge (C) et le circuit de coupure (s0 à s3), un module d'émission/réception est associé aussi bien au calculateur de charge (C) qu'au circuit de coupure (s0 à s3), et que la transmission des signaux sous la forme de signaux codés est réalisée par l'intermédiaire de la ligne (3) d'alimentation en énergie électrique de l'appareil (10 à 13).

25. Système selon la revendication 20, caractérisé par le fait qu'on utilise, comme détecteur (20 à 23) pour le courant aboutissant à l'appareil (10 à 13) ou au groupe d'appareils, un détecteur électrique détectant la position du circuit de coupure (s0 à s3).

26. Système suivant la revendication 20, caractérisé par le fait que, dans le cas d'appareils (10 à 13), dont la puissance dissipée est variable pendant un cycle de travail, en aval du détecteur (20 à 23) se trouve branché un transmetteur de valeur limite, dont le signal de sortie n'est actif que dans le cas d'exécutions de tâches, réalisées avec une grande puissance, du cycle de travail.

27. Système suivant les revendications 6 à 16, caractérisé par le fait qu'une commutation de tarif du compteur électrique (Z) peut être déclenchée par le calculateur de charge (C), lorsque le calcul préalable du maximum de puissance, auquel on peut s'attendre, permet de s'attendre à un dépassement de la valeur limite.

FIG 1

FIG 2